# EUROPEAN PATENT APPLICATION

(11) **EP 3 270 051 A1**
(43) Date of publication of application: **17.01.2018**
(21) Application number: 16761240.7
(22) Date of filing: 15.02.2016
(51) Int. Cl.: F21V 9/16, F21V 19/00, F21Y 115/10

(54) **LIGHT-EMITTING DEVICE AND MANUFACTURING METHOD FOR LIGHT-EMITTING DEVICE**

(30) Priority: 11.03.2015 JP 2015048800
(71) Applicant: Panasonic Intellectual Property Management Co., Ltd., Osaka-shi, Osaka 540-6207 (JP)
(72) Inventor: SUZUKI, Masanori, Osaka-shi, Osaka 540-6207 (JP); NAKAMURA, Akifumi, Osaka-shi, Osaka 540-6207 (JP); GODA, Jun, Osaka-shi, Osaka 540-6207 (JP); UEMI, Hirotaka, Osaka-shi, Osaka 540-6207 (JP)
(74) Representative: Müller-Boré & Partner Patentanwälte PartG mbB
(86) International application number: PCT/JP2016/000751
(87) International publication number: WO 2016/143261

(57) **Abstract**

A light-emitting device includes a substrate (101); a plurality of light-emitting elements (102) attached to a surface of the substrate (101); a first resin part (103) that collectively covers the plurality of light-emitting elements (102) and contains a light-converting substance that, based on light emitted by the plurality of light-emitting elements (102), emits light different from the light emitted by the plurality of light-emitting elements (102); a second resin part (104) that contains a light-converting substance and whose ability to convert light is different from that of the first resin part (103), wherein the second resin part (104) is disposed on a surface of the first resin part (103) at a position that does not intersect with individual optical axes (121), being optical axes of the plurality of light-emitting elements (102).

## Description

### TECHNICAL FIELD

The present invention relates to a light-emitting device and a manufacturing method for a light-emitting device.

### BACKGROUND ART

Solid-state light-emitting elements, such as light-emitting diodes (LEDs), are widely used in a variety of devices as high-efficiency, compact light sources. For example, light-emitting devices including LEDs are used as light sources for lighting purposes as well as for backlights in liquid crystal displays.

In order to produce white light using such a solid-state light-emitting element exemplified by an LED, for example, a combination of a blue LED that emits blue light and a yellow phosphor that is excited by blue light (excitation light) from the blue LED and emits yellow light via fluorescence is used to artificially produce white light.

Here, in order for the LED to emit light onto the phosphor, the LED is covered by a clear resin containing dispersed phosphor. Further, in order to inhibit variation in chromaticity across light-emitting devices (i.e., color matching), the chromaticity of the artificial white light is adjusted by attaching via, for example, coating, another resin containing a different phosphor onto a portion of the surface of the above-described resin (see Patent Literature (PTL) 1).

### Citation List

### Patent Literature

PTL 1: Japanese Unexamined Patent Application Publication No. 2014-99650

### SUMMARY OF THE INVENTION

### TECHNICAL PROBLEMS

However, depending on the state of the second resin formed on the surface of the first resin, there are instances when the variances in chromaticity are exacerbated due to, for example, an inability to produce a desired chromaticity because of an insufficient amount of change in chromaticity even when a chromaticity adjustment process is performed, or due to an overshoot of the desired chromaticity resulting from an excessive change in chromaticity. Moreover, there are instances where a phenomenon occurs where the chromaticity changes depending on the viewing angle when the light chromaticity distribution is not consistent in the light-emitting device. Moreover, with such a light-emitting device, color matching cannot be accurately performed across light-emitting devices.

As a result of diligent experimentation and research by the inventors, the inventors discovered that it is possible to minimize inconsistencies in the light chromaticity distribution by placing the second resin a predetermined state.

The present invention is based on the above knowledge, and has an object to provide a light-emitting device in which occurrence of an inconsistent light chromaticity distribution is inhibited and chromaticity is controlled such that the chromaticity across light-emitting devices matches, as well as a manufacturing method for such a light-emitting device.

### SOLUTIONS TO PROBLEMS

In order to achieve the above object, a light-emitting device according to the present invention includes: a substrate; a plurality of light-emitting elements attached to a surface of the substrate; a first resin part that collectively covers the plurality of light-emitting elements and contains a light-converting substance that, based on light emitted by the plurality of light-emitting elements, emits light different from the light emitted by the plurality of light-emitting elements; and a second resin part that contains a light-converting substance and whose ability to convert light is different from that of the first resin par. The second resin part is disposed on a surface of the first resin part at a position that does not intersect with individual optical axes which are optical axes of the plurality of light-emitting elements.

Moreover, in order to achieve the above object, a manufacturing method for a light-emitting device including a substrate, a plurality of light-emitting elements attached to a surface of the substrate, and a first resin part that collectively covers the plurality of light-emitting elements and contains a light-converting substance that, based on light emitted by the plurality of light-emitting elements, emits light different from the light emitted by the plurality of light-emitting elements, includes forming a second resin part that contains a light-converting substance and whose ability to convert light is different from that of the first resin part, on a surface of the first resin part that is cured, at a position that does not intersect with individual optical axes which are optical axes of the plurality of light-emitting elements.

### ADVANTAGEOUS EFFECTS OF INVENTION

With the present invention, it is possible to shift chromaticity and still inhibit an inconsistent light chromaticity distribution, therefore making it possible to perform a desired chromaticity adjustment. Moreover, it is possible to provide a light-emitting device which produces matching chromaticity across light-emitting devices as a result of the chromaticity adjustment.

### BRIEF DESCRIPTION OF DRAWINGS

FIG. 1 is a plan view illustrating a light-emitting device from above;
FIG. 2 is a cross sectional view illustrating a light-emitting device with a portion thereof omitted;
FIG. 3 is a perspective view illustrating a light-emitting device and virtual planes of symmetry from above;
FIG. 4 illustrates an xy chromaticity graph showing a chromaticity adjustment principle with respect to a light-emitting device;
FIG. 5 is a cross sectional view illustrating a light-emitting device according to another embodiment with a portion thereof omitted;
FIG. 6 is across sectional view illustrating the height difference between the surface of a first resin part and the surface of a second resin part;
FIG. 7 is a plan view illustrating a light-emitting device from above during the forming of depressions;
FIG. 8 is a plan view illustrating one example of second resin part and third resin part patterns: and
FIG. 9 is a plan view illustrating another example of second resin part and third resin part patterns.

### DESCRIPTION OF EXEMPLARY EMBODIMENT(S)

The following describes embodiments of a light-emitting device and manufacturing method for a light-emitting device according to the present invention with reference to the drawings. Note that the embodiments described below are merely examples of a light-emitting device and manufacturing method for a light-emitting device according to the present invention. Accordingly, the scope of the present invention is defined by the appended claims with reference to the embodiments, and not by the embodiments themselves. Therefore, among elements in the following embodiments, those not recited in any of the independent claims defining the broadest concept of the present invention are not absolutely necessary for achieving the advantageous effects of the present invention, but are described as elements for producing a preferred embodiment.

Moreover, the drawings may include exaggerations or omissions for the purpose of illustrating the present invention, and may be schematic drawings whose scale is modified from the actual shapes, positional relationships, and/or scale.

### EMBODIMENT 1

### (Light-emitting Device)

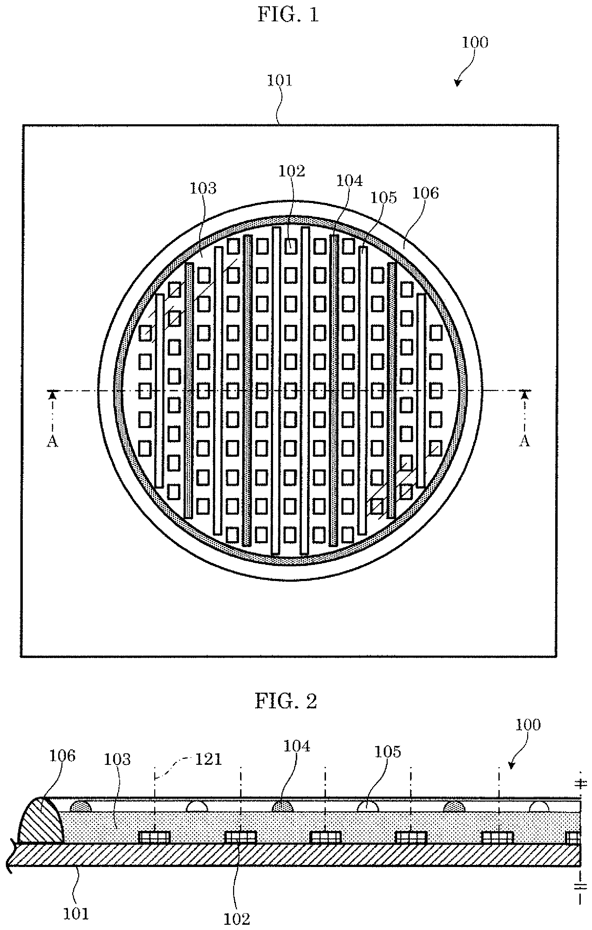

FIG. 1 is a plan view illustrating a light-emitting device from above.

FIG. 2 is a cross sectional view illustrating a light-emitting device with a portion thereof omitted, taken at line A-A in FIG. 1.

As illustrated in these figures, light-emitting device 100 is a device that emits light by causing light-emitting elements 102 attached to the surface of substrate 101 to emit light by supplying light-emitting elements 102 with power, and includes, in addition to substrate 101 and light-emitting elements 102, first resin part 103 and second resin part 104. In this embodiment, light-emitting device 100 further includes third resin part 105 and bank 106.

Substrate 101 is a plate-like component that holds light-emitting elements 102 in a predetermined arrangement and includes power lines (not illustrated in the drawings) for supplying power to the held light-emitting elements 102. Substrate 101 is not limited to any particular shape. Moreover, the material of substrate 101 is not limited to any particular material, and may be, for example, metal, resin, ceramic, or glass.

Substrate 101 is preferably capable of guiding light emitted from light-emitting elements 102 toward substrate 101 and reflecting the light guided from between light-emitting elements 102 off the surface onto which light-emitting elements 102 are attached. This is because it improves light emission efficiency. Examples of such a substrate 101 include a white ceramic substrate formed by sintering, for example, alumina. Such a substrate 101 is capable of simultaneously guiding and scattering (diffusedly reflecting) light emitted by light-emitting elements 102 toward substrate 101 and emit light from between light-emitting elements 102.

Examples of the resin used in substrate 101 include, specifically, glass epoxy made of fiber glass and epoxy resin, and polyimide. When substrate 101 is a resin substrate, substrate 101 can be made to be flexible.

Examples of metal used in substrate 101 include, specifically, aluminum alloy substrate, iron alloy, and copper alloy. Note that when substrate 101 is a metal substrate, in order to insulate light-emitting elements 102, substrate 101 may include an insulating film (resist) between each light-emitting element 102 and metal parts. Note that the insulating film is preferably a film that is highly reflective, such as a white resist, so as to increase the light emission efficiency of light-emitting device 100.

Light-emitting elements 102 are attached to the surface of substrate 101 and emit light of single wavelength or nearly a single wavelength based on power supplied using lines provided on substrate 101. Light-emitting elements 102 are, for example, specifically light-emitting diodes (LEDs). In this embodiment, light-emitting elements 102 are light-emitting diodes made of inorganic semiconductors, and are attached to substrate 101 such that the optical axis of each light-emitting element 102, which indicates a direction of the part of the light having the highest luminous intensity in the light distribution of a single light-emitting element 102, intersects (perpendicularly) the surface of substrate 101 on which light-emitting elements 102 are attached. Moreover, light-emitting elements 102 also emit light toward substrate 101. Note that in this description and in the appended claims, the above-described optical axes are referred to as individual optical axes 121. This is to differentiate between the optical axis of light-emitting device 100 as a whole.

Light-emitting elements 102 emit light of a shorter wavelength than yellow, and more specifically, emit blue light. Moreover, light-emitting elements 102 are semiconductor elements not provided in a package, but directly mounted to substrate 101 (i.e., are bare chips). Thus, in this embodiment, light-emitting device 100 has a chip on board (COB) structure.

First resin part 103 is a resin component containing a light-converting substance that emits light different from light emitted from light-emitting elements 102, based on light emitted from light-emitting elements 102. Moreover, first resin part 103 is disposed so as to collectively cover the plurality of light-emitting elements 102 disposed on substrate 101.

In this embodiment, light-emitting device 100 includes annular bank 106 on the surface of substrate 101 that surrounds light-emitting elements 102, and first resin part 103 fills the inside of the bowl-shaped portion formed by substrate 101 and bank 106. This planarizes the surface of first resin part 103.

The light-converting substance included in first resin part 103 includes at least one of (i) a fluorescent substance that is excited by light emitted by light-emitting elements 102 and emits light of a different wavelength than the light emitted by light-emitting elements 102 and (ii) a filter substance such as a pigment or dye that absorbs (does not transmit) wavelengths of some of the light emitted by either light-emitting elements 102 or the fluorescent substance.

In this embodiment, the light-converting substance included in first resin part 103 includes a fluorescent substance. The fluorescent substance emits fluorescent light upon being excited by light (blue light) emitted by light-emitting elements 102, and emits light of a different color (yellow) than the light emitted by light-emitting elements 102. With this, overall, light-emitting device 100 emits both blue light emitted by light-emitting elements 102 and yellow light emitted by the light-converting substance, and these lights appear (artificially) as white light to a person looking at these lights collectively. Note that the light-converting substance included in first resin part 103 may include a plurality of types of fluorescent substances, and by changing the ratios of the amounts of each type of fluorescent light, the chromaticity of the white light can be effectively adjusted.

The resin included in first resin part 103 holds the light-converting substance in a dispersed state, and has a light transmitting property that allows for the light emitted by light-emitting elements 102 and the light converted by the light-converting substance to pass through. Specific examples include resin, silicone resin, and epoxy resin.

One example of the light-converting substance is a YAG (yttrium aluminum garnet) fluorescent substance. YAG is a substance that enables the emission of yellow light based on the blue light emitted by light-emitting elements 102. Examples of the other fluorescent substances included as a light-converting substance include CASN (CaAlSiN3:Eu). This is a substance that emits red light based on the light emitted by light-emitting elements 102, and adjusts the spectrum of the light emitted overall by light-emitting device 100, and therefore adjusts the chromaticity of the artificial white light. The light-converting substance may also additionally or alternatively include a fluorescent substance that emits green light.

First resin part 103 may further dispersedly include a light-diffusing material. A light-diffusing material is, for example, fine silica particles, and as such, light emitted by light-emitting elements 102 or light converted by light-converting substance is scattered (diffusedly reflected) whereby the appearance of the individual light-emitting elements 102 is reduced such that a person perceives the overall light-emitting device 100 as emitting light across an entire surface.

Second resin part 104 is a resin component that contains a light-converting substance and whose ability to convert light is different from that of first resin part 103. Here, "whose ability to convert light is different" means that under the same conditions including the same light being incident, when the overall light emitted by first resin part 103 and the overall light emitted by second resin part 104 are viewed or measured, the perception, chromaticity, and/or spectrum of the respective lights is/are different. Therefore, even if first resin part 103 and second resin part 104 are made from the same type of resin and contain the same type of light-converting substance, when the concentration of the light-converting substance is different, the ability to convert light is different.

The light-converting substance included in second resin part 104 includes at least one of (i) a fluorescent substance that is excited by light emitted by light-emitting elements 102 and emits light of a different wavelength than the light emitted by light-emitting elements 102 and (ii) a filter substance such as a pigment or dye that absorbs (does not transmit) wavelengths of some of the light emitted by either light-emitting elements 102 or the fluorescent substance. In other words, the light-converting substance converts (shifts) the wavelength of the light emitted by light-emitting elements 102 to a longer wavelength.

Second resin part 104 is disposed on the surface of first resin part 103 in a position that does not intersect with individual optical axes 121 of light-emitting elements 102, and light-emitting elements 102 are not present inward of second resin part 104. This sort of arrangement is employed to make use of the fact that the critical angle is small at the interface between the air and first resin part 103 or second resin part 104 with respect to short wavelength light (blue light) emitted by light-emitting elements 102 and that the critical angle is large relative to long wavelength light (yellow or red light).

In other words, even if second resin part 104 were disposed in a position directly above and separated from light-emitting elements 102, blue light emitted by light-emitting elements 102 can pass through without being reflected at the interface between first resin part 103 and second resin part 104, and as such, a large amount of blue light enters second resin part 104 and thus a large amount of blue light is converted into long wavelength light by the light-converting substance included in second resin part 104. Therefore, a large amount of long wavelength light (yellow or red light) based on the blue light emitted by light-emitting elements 102 is efficiently emitted. Moreover, when second resin part 104 is disposed directly above light-emitting elements 102, second resin part 104 functions like a lens relative to the blue light, and since the overall color tone changes if the position of second resin part 104 relative to light-emitting elements 102 is even slightly off, second resin part 104 needs to be positioned with precision thereby requiring highly precise manufacturing processes.

As described above, since second resin part 104 is arranged on the surface of first resin part 103 in a position that does not intersect with individual optical axes 121 of light-emitting elements 102, the chromaticity of light-emitting device 100 can be precisely adjusted, and adjustment for matching chromaticity across light-emitting devices 100 can be easily carried out.

Further, in this embodiment, since the surface of first resin part 103 is planarized, the positional relationship between light-emitting elements 102 and second resin part 104 is stable, making it possible to reduce errors in chromaticity across light-emitting devices 100 that occur when second resin parts 104 are arranged under the same conditions.

Moreover, second resin parts 104 are arranged extending in linear shapes ("linear shape" includes straight and curved line shapes) between light-emitting elements 102 disposed in a matrix at even intervals inside the annular bank 106. This makes it possible to arrange second resin part 104 in a shape that is more stable than when arranged in a dot-like shape, which makes it possible to stabilize the chromaticity adjusted by second resin part 104.

Moreover, second resin part 104 is disposed in an annular shape so as to collectively surround light-emitting elements 102. This makes it possible to dispose second resin part 104 relatively largely, making it possible to easily adjust the overall chromaticity of light-emitting device 100.

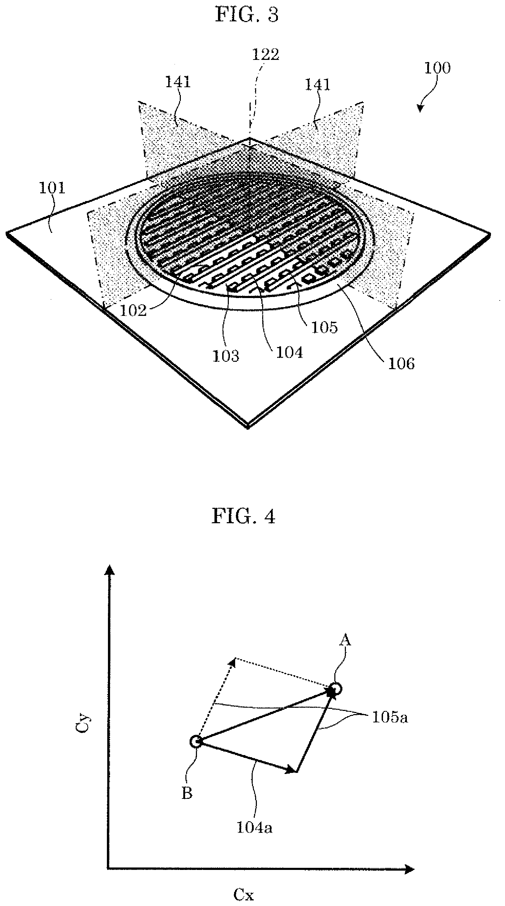

Moreover, as illustrated in FIG. 3, second resin part 104 is arranged so as to be symmetrical about virtual planes of symmetry 141 that intersect substrate 101. There are at least two planes of symmetry 141. Further, the line of intersection of the two planes of symmetry 141 match the overall optical axis of light-emitting device 100 (hereinafter also referred to as overall optical axis 122 in order to differentiate between the individual optical axes). By arranging second resin part 104 so as to have plane symmetry, even when second resin parts 104 having different light converting abilities are arranged on the surface of first resin part 103, inconsistencies in the overall chromaticity distribution of light-emitting device 100 can be effectively inhibited.

Second resin part 104 includes a light-converting substance that emits light of a longer wavelength than first resin part 103. Here, long wavelength light refers to the spectrum peak of light emitted by second resin part 104 being longer in wavelength than the spectrum peak of light emitted by first resin part 103. More specifically, it refers to second resin part 104 including a fluorescent substance that emits red light as the light-converting substance, and the concentration of the fluorescent substance that emits red light being greater than the concentration of the fluorescent substance that emits red light included in first resin part 103, or second resin part 104 including only a fluorescent substance that emits red light as the light-converting substance.

The resin included in second resin part 104 is not limited to any particular resin, and in this embodiment, is the same type of resin that is included in first resin part 103.

Third resin part 105 is a resin component that contains a light-converting substance and whose ability to convert light is different from that of first resin part 103 and second resin part 104. Similar to second resin part 104, third resin part 105 is disposed on the surface of first resin part 103 in a position that is different from second resin part 104 and does not intersect with individual optical axes 121 of light-emitting elements 102.

By arranging second resin part 104 and third resin part 105 which have mutually different light conversion abilities on the surface of first resin part 103, it is easy to shift initial chromaticity B of light-emitting device 100 in a state in which second resin part 104 and third resin part 105 are not arranged to target chromaticity A, as illustrated in the xy chromaticity graph in FIG. 4. In other words, second chromaticity vector 104a that indicates the direction and magnitude of the shift in chromaticity of light-emitting device 100 as a result of forming second resin part 104, and third chromaticity vector 105a that indicates the direction and magnitude of the shift if chromaticity of light-emitting device 100 as a result of forming third resin part 105 make it possible to easily shift initial chromaticity B of light-emitting device 100 to target chromaticity A as if it were a vector sum. Therefore, it is possible to easily adjust chromaticity across light-emitting devices 100.

In this embodiment, third resin parts 105 are arranged extending in linear shapes ("linear shape" includes straight and curved line shapes) along second resin part 104 and between light-emitting elements 102. Moreover, third resin part 105 has plane symmetry about planes of symmetry 141 of second resin part 104 as well. First resin part 103 also has plane symmetry about planes of symmetry 141 of second resin part 104. This makes it possible to inhibit inconsistencies in light chromaticity distribution of light-emitting device 100 and adjust the chromaticity of light-emitting device 100 with a high degree of freedom.

Note that it is desirable that second resin part 104 and third resin part 105 be alternately arranged to the greatest extent possible. With such an arrangement, it is possible to inhibit inconsistencies in light chromaticity distribution of light-emitting device 100.

### EMBODIMENT 2

Next, Embodiment 2 will be described. Note that elements that achieve the same effects and functions as in Embodiment 1, and elements that have the same shapes, mechanisms, and structures as in Embodiment 1 share like reference signs, and description thereof may be omitted. Moreover, the following will focus on the points of difference with Embodiment 1, and description of overlapping content may be omitted.

### (Light-emitting Device)

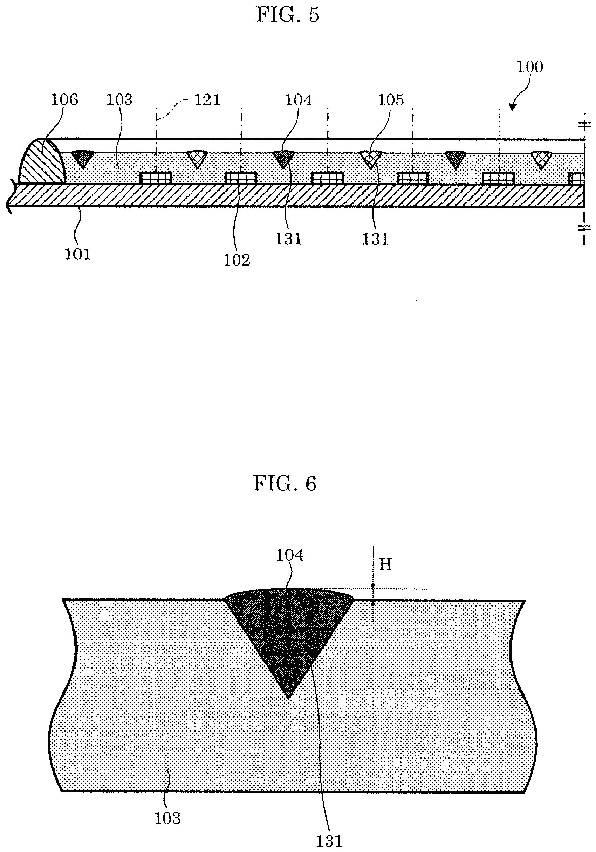

FIG. 5 is a cross sectional view illustrating the light-emitting device according to this embodiment with a portion including the overall optical axis of the light-emitting device omitted.

In the same figure, first resin part 103 includes a plurality of depressions 131 in the surface of first resin part 103 at positions that do not intersect with individual optical axes 121 of light-emitting elements 102. Moreover, second resin part 104 is arranged seated inside depressions 131. In this embodiment, third resin part 105 is also arranged seated inside depressions 131. Moreover, depressions 131 including line-shaped grooves arranged lined up and extending in one direction between light-emitting elements 102, and an annular groove that surrounds the region in which light-emitting elements 102 are arranged.

By arranging second resin part 104 and third resin part 105 in depressions 131 in this way, compared to when second resin part 104 and third resin part 105 are arranged on the planar surface of first resin part 103, joint strength with first resin part 103 can be increased. In particular, by forming depressions 131 in the surface of first resin part 103 using laser light, joint strength between first resin part 103 and second resin part 104 and joint strength between first resin part 103 and third resin part 105 can be increased.

Moreover, when second resin part 104 and third resin part 105 are formed by being coated on, the shapes of second resin part 104 and third resin part 105 formed by coating resin in depressions 131 can be stabilized and the chromaticity of light-emitting device 100 post-adjustment can be stabilized. Further, since the distance between each of second resin part 104 and third resin part 105 and light-emitting elements 102 is less than when second resin part 104 and third resin part 105 are provided on the surface of first resin part 103, the light emitted by light-emitting elements 102 is incident on second resin part 104 and third resin part 105 in greater quantity, and second resin part 104 and third resin part 105 can markedly contribute to the adjustment of the chromaticity of light-emitting device 100. Further, due to the inclusion of depressions 131, since the overall amount of light-converting substance in first resin part 103 decreases, second resin part 104 and third resin part 105 can markedly contribute to the adjustment of the chromaticity of light-emitting device 100.

Moreover, the surface of first resin part 103 and the surface of second resin part 104 are preferably substantially flush. With this, it is possible to inhibit inconsistencies in light chromaticity distribution of light-emitting device 100. Here, the surface of first resin part 103 and the surface of second resin part 104 being substantially flush means, for example, as illustrated in FIG. 6, that the difference H between the surface of first resin part 103 and the surface of second resin part 104 is within ±0.2 mm.

### (Manufacturing Method for Light-emitting Device)

Light-emitting device 100 according to this embodiment can be manufactured, for example, as follows.

First, light-emitting elements 102 is surface-mounted on substrate 101 provided with predetermined lines. Surface-mounting may include wire bonding light-emitting elements 102 with lines provided on substrate 101.

Next, bank 106 is formed so as to surround all light-emitting elements 102 attached to the surface of substrate 101. The method of forming bank 106 is not particularly limited, but for example, bank 106 can be formed by moving one or both of a nozzle and substrate 101 relative to the other and dispensing so as to apply a predetermined resin via the nozzle into an annular shape, and curing the applied resin. Moreover, when bank 106 is not required, this step may be omitted.

Next, first resin part 103 is formed so as to collectively cover light-emitting elements 102. In this embodiment, resin for forming first resin part 103 is filled in the bowl-shaped portion formed by bank 106 and substrate 101. In this case, a relatively low viscosity resin may be used to fill the bowl-shaped portion with resin. This makes it possible to planarize the surface of first resin part 103 formed as a result of being cured.

Note that the steps up until now and the steps from here on out may be performed in succession, and, alternatively, the steps from here on out may be performed on light-emitting device 100 manufactured as a product by separately performing the steps up until now.

Next, light-emitting device 100 in this state is caused to emit light with rated power and the chromaticity of light-emitting device 100 is measured. Note that when the chromaticity of light-emitting device 100 is known in advance, this step can be omitted. Then, based on initial chromaticity B, which is the measured chromaticity (or known chromaticity), and target chromaticity A, which is the chromaticity aimed for (see FIG. 4), the state of second resin part 104 and the state of third resin part 105 are determined. The state of second resin part 104 and the state of third resin part 105 include parameters for determining a color tone vector indicating the direction and magnitude of a shift in chromaticity of light-emitting device 100 as a result of forming each of second resin part 104 and third resin part 105. More specifically, such a parameter includes the type, concentration, and overall amount of light-converting substance, the arrangement of second resin part 104 and third resin part 105, and the depth of depressions 131.

Based on the above parameter, depressions 131 are formed in the surface of the formed first resin part 103. Here, when the positions of light-emitting elements 102 on substrate 101 are unclear due to, for example, the presence of first resin part 103, positional information indicating the positions of light-emitting elements 102 on substrate 101 by causing light-emitting elements 102 to emit light may be generated, and depressions 131 may be formed based on the generated positional information. This also applies to the forming of second resin part 104 even when depressions 131 are not formed. More specifically, for example, light-emitting elements 102 are caused to emit a little bit of light by supplying light-emitting elements 102 with 50% of the rated current or less, imaging light-emitting elements 102 in this state, and analyzing the obtained image to generate the positional information.

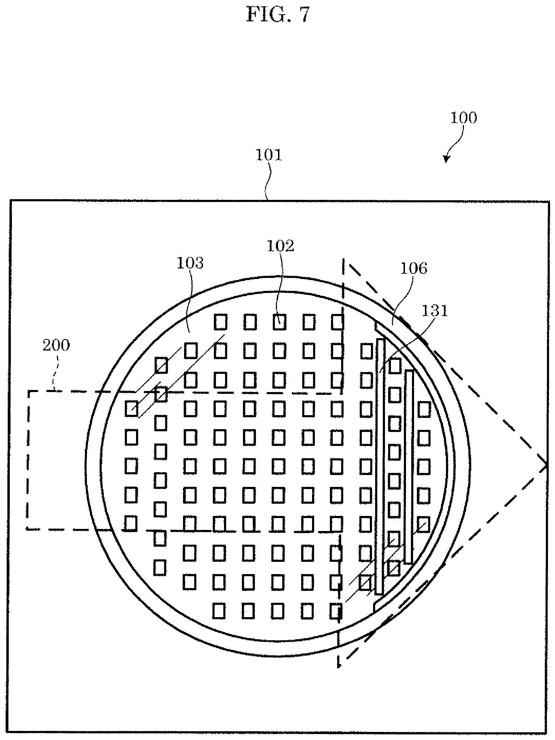

Moreover, as illustrated in FIG. 7, when depressions 131 are formed using laser light, airflow 200 is preferably generated, by an airflow generator (not shown in the drawings), on the surface of first resin part 103 that blows, in one direction, dust produced upon forming depressions 131, and depressions 131 are preferably formed from downstream to upstream of airflow 200. With this, dust produced upon forming depressions 131 can be prevented from being burnt by the laser light when the next depression 131 is formed, making it possible to form depressions 131 whose interfaces are clear. Note that the airflow generator is not particularly limited. For example, the opening of a nozzle may be arranged near the outer perimeter of substrate 101, and air may be sucked from the nozzle to generate airflow 200. Note that when depressions 131 are not required, this step may be omitted.

Next, second resin part 104 is formed in (or on the surface of) depressions 131 formed in the surface of first resin part 103. In this case, it is preferable that a liquid resin for forming second resin part 104 be prepared and second resin part 104 be formed by filling depressions 131 with the resin. With this, the surface of first resin part 103 and the surface of second resin part 104 can be easily made to be flush with one another. Note that one example of a method for coating liquid resin is a jet dispenser method.

Next, third resin part 105 is formed in a similar fashion to second resin part 104.

With this, light-emitting device 100 capable of emitting light of a desired chromaticity is manufactured.

### (Working Effect of Light-emitting Device)

With light-emitting device 100 according to this embodiment, light of a desired chromaticity is emitted due to second resin part 104 and third resin part 105 being formed on the surface of first resin part 103 Therefore, it is possible to minimize variations in chromaticity across light-emitting devices 100, making it possible to easily provide a stable product. In other words, in a light-emitting device 100 manufactured up through the forming of first resin part 103, light-emitting elements 102 are caused to emit light, the chromaticity is measured, and when the measured chromaticity is not within a predetermined range, it is possible to form second resin part 104 and third resin part 105 so as to shift the chromaticity of light-emitting device 100 to bring the chromaticity of light-emitting device 100 within the predetermined range.

Moreover, it is possible to minimize inconsistencies in light chromaticity distribution of the light emitted by light-emitting device 100.

Note that the present invention is not limited to the above embodiment. More specifically, elements recited in the present description may be arbitrarily combined and/or one or more elements may be omitted to produce other embodiments of the present invention. Moreover, so long as they are within the spirit of the present invention-that is to say, so long as they do not depart from the scope of the appended claims-variations conceived by those skilled in the art resulting from modifying the above embodiment are included within the present invention.

For example, bank 106 may be omitted from light-emitting device 100 when light-emitting elements 102 can be collectively sealed by first resin part 103.

Moreover, regarding the manufacturing method for light-emitting device 100, the method was described as including forming depressions 131, but depressions 131 may be omitted from first resin part 103 and second resin part 104 and third resin part 105 may be formed on the surface of first resin part 103.

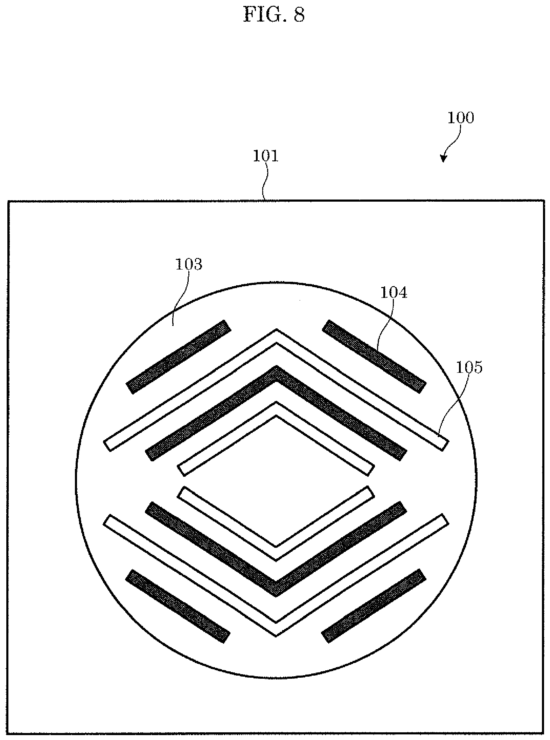

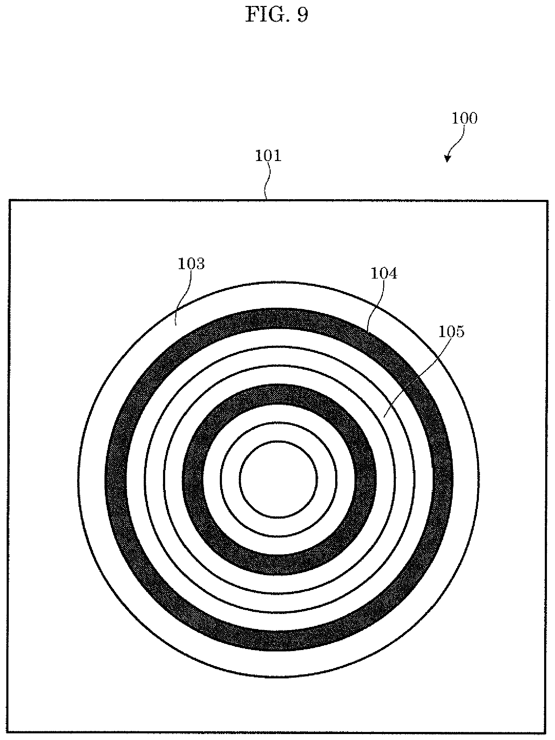

Second resin part 104 and third resin part 105 may be arranged so as to include bends, as illustrated in FIG. 8, and, alternatively, may be arranged in concentric circles, as illustrated in FIG. 9. Moreover, second resin part 104 and third resin part 105 may be curved so as to weave between light-emitting elements 102. Further, second resin part 104 and third resin part 105 may be arranged in a mesh pattern, and, alternatively, may be arranged in dot or island patterns.

Moreover, patterns for second resin part 104 and depressions 131 may be arbitrarily selected within the scope as defined by the present invention.

Moreover, when adjusting the chromaticity of light-emitting device 100, the state of second resin part 104 and third resin part 105 is determined after measuring the chromaticity, but chromaticity may be gradually measured as second resin part 104 and third resin part 105 are gradually formed, and at the point in time when target chromaticity A is reached, the forming of second resin part 104 and third resin part 105 may be completed.

Moreover, light-emitting elements 102 may emit ultraviolet light that is shorter in wavelength than blue light. Light-emitting elements 102 may be semiconductor laser light-emitting elements, organic EL (electro-luminescent) light-emitting elements, or other solid-state light-emitting elements. Moreover, light-emitting elements 102 may be package-type light-emitting elements.

### REFERENCE MARKS IN THE DRAWINGS

- 100: light-emitting device
- 101: substrate
- 102: light-emitting element
- 103: first resin part
- 104: second resin part
- 105: third resin part
- 121: individual optical axes
- 131: depression
- 141: plane of symmetry
- 200: airflow

## Claims

1. A light-emitting device, comprising:
a substrate;
a plurality of light-emitting elements attached to a surface of the substrate;
a first resin part that collectively covers the plurality of light-emitting elements and contains a light-converting substance that, based on light emitted by the plurality of light-emitting elements, emits light different from the light emitted by the plurality of light-emitting elements; and
a second resin part that contains a light-converting substance and whose ability to convert light is different from that of the first resin part,
wherein the second resin part is disposed on a surface of the first resin part at a position that does not intersect with individual optical axes which are optical axes of the plurality of light-emitting elements.

2. The light-emitting device according to claim 1, wherein
the first resin part includes a plurality of depressions in the surface at positions that do not intersect with the individual optical axes of the plurality of light-emitting elements, and
the second resin part is disposed in the plurality of depressions.

3. The light-emitting device according to claim 2, wherein
the surface of the first resin part and a surface of the second resin part are substantially flush.

4. The light-emitting device according to any one of claims 1 to 3, further comprising
a third resin part that contains a light-converting substance and whose ability to convert light is different from that of the first resin part and the second resin part,
wherein the third resin part is disposed on the surface of the first resin part at a position that is different from the second resin part and does not intersect with the individual optical axes of the plurality of light-emitting elements, and
the second resin part and the third resin part are arranged so as to have plane symmetry about at least two planes of symmetry that intersect with the substrate.

5. The light-emitting device according to any one of claims 1 to 4,
wherein
the light-converting substance contained in the second resin part emits light of a longer wavelength than the first resin part.

6. A manufacturing method for a light-emitting device including a substrate, a plurality of light-emitting elements attached to a surface of the substrate, and a first resin part that collectively covers the plurality of light-emitting elements and contains a light-converting substance that, based on light emitted by the plurality of light-emitting elements, emits light different from the light emitted by the plurality of light-emitting elements, the manufacturing method comprising
forming a second resin part that contains a light-converting substance and whose ability to convert light is different from that of the first resin part, on a surface of the first resin part that is cured, at a position that does not intersect with individual optical axes which are optical axes of the plurality of light-emitting elements.

7. The manufacturing method according to claim 6, comprising
forming a depression in the surface of the cured first resin part at a position that does not intersect with the individual optical axes of the plurality of light-emitting elements, and
forming the second resin part in the depression.

8. The manufacturing method according to claim 7, comprising
generating, by an airflow generator, airflow on the surface of the first resin part that blows, in one direction, dust produced upon forming the depression, and
forming the depression using laser light from downstream to upstream of the airflow.

9. The manufacturing method according to any one of claims 6 to 8, further comprising
generating positional information indicating positions of the plurality of light-emitting elements on the substrate by causing the light-emitting elements to emit light,
wherein the second resin part is formed based on the positional information.
